# EUROPEAN PATENT APPLICATION

(11) **EP 4 299 659 A1**
(43) Date of publication of application: **03.01.2024**
(21) Application number: 22887560.5
(22) Date of filing: 25.10.2022
(51) Int. Cl.: C08K 5/5415, C08K 5/00, C08L 23/08, C08J 5/18, H01L 31/048

(54) **COMPOSITION FOR ENCAPSULATION FILM, AND ENCAPSULATION FILM COMPRISING SAME**

(30) Priority: 28.10.2021 KR 20210145164
(71) Applicant: LG Chem, Ltd., Yeoui-daero, Youngdungpo-gu Seoul 07336 (KR)
(72) Inventor: GONG, Jin Sam, Daejeon 34122 (KR); LEE, Eun Jung, Daejeon 34122 (KR); PARK, Sang Eun, Daejeon 34122 (KR); HONG, Sang Hyun, Daejeon 34122 (KR); LEE, Jin Kuk, Daejeon 34122 (KR); KIM, Jong Gil, Daejeon 34122 (KR); HAN, Sang Wook, Daejeon 34122 (KR)
(74) Representative: Hoffmann Eitle
(86) International application number: PCT/KR2022/016355
(87) International publication number: WO 2023/075364

(57) **Abstract**

The present invention relates to: a composition for an encapsulation film, comprising an ethylene-α-olefin copolymer; an encapsulation film; and a solar cell module. When an encapsulation film is manufactured using the composition for an encapsulation film, according to the present invention, the dipping time of the ethylene-α-olefin copolymer is reduced, and thus the economic feasibility of producing an encapsulation film can be improved. In addition, the composition for an encapsulation film, prepared using the present invention, exhibits an excellent degree of crosslinking.

## Description

### TECHNICAL FIELD

### Cross-reference to Related Applications

This application claims the benefit of Korean Patent Application No. 2021-0145164, filed on October 28, 2021, in the Korean Intellectual Property Office, the contents of which are incorporated herein by reference.

### Technical Field

The present invention relates to a composition for an encapsulant film, comprising an ethylene/alpha-olefin copolymer, an encapsulant film and a solar cell module.

### BACKGROUND ART

As global environmental problems, energy problems, etc. get worse and worse, solar cells receive attention as an energy generating means without fear of environmental contamination and exhaustion. If solar cells are used outside such as the roof of a building, generally, a module type of the solar cells is used. In order to obtain a crystalline solar cell module when manufacturing a solar cell module, front glass/solar cell encapsulant/crystalline solar cell device/solar cell encapsulant/rear glass (or rear protection sheet) are stacked in order. As the encapsulant of the solar cells, generally, an ethylene/vinyl acetate copolymer or ethylene/alpha-olefin copolymer having excellent transparency, flexibility, adhesiveness, etc. is used.

A solar cell module is obtained by protecting a solar cell device such as silicon, gallium-arsenic, and copper-indium-selenium using an upper transparent protecting material and a lower substrate protecting material, and packaging by fixing the solar cell device and the protecting materials using a sealant. Generally, the sealant of the solar cell device in a solar cell module is formed by extrusion molding of an ethylene/alpha-olefin copolymer mixed with an organic peroxide or a silane coupling agent into a sheet type, and the solar cell device is sealed by using the sheet type sealant to manufacture a solar cell module.

In case of manufacturing the above-described solar cell module, the increase of the affinity of an ethylene/alpha-olefin copolymer with various materials included in a composition for an encapsulant film to improve absorbency may be a way of increasing productivity. Particularly, a crosslinking agent, a crosslinking auxiliary agent, or the like, required to use for the manufacture of an encapsulant film are polar materials and have low absorbency with respect to a nonpolar ethylene/alpha-olefin copolymer, and accordingly, are acknowledged to be one of the factors inducing the reduction of productivity.

### [Prior Art Document]

### [Patent Document]

(Patent Document 1) Japanese Laid-open Patent No. 2015-211189

### DISCLOSURE OF THE INVENTION

### TECHNICAL PROBLEM

An object of the present invention is to use a crosslinking agent, a crosslinking auxiliary agent, or the like, having high affinity with an ethylene/alpha-olefin copolymer to reduce the immersion time of the ethylene/alpha-olefin copolymer at an initiation step during manufacturing an encapsulant film.

### TECHNICAL SOLUTION

To solve the above tasks, the present invention provides a composition for an encapsulant film, an encapsulant film, and a solar cell module.
(1) The present invention provides a composition for an encapsulant film, comprising an ethylene/alpha-olefin copolymer, a crosslinking agent, a crosslinking auxiliary agent and a silane coupling agent, wherein the crosslinking auxiliary agent comprises a compound represented by Formula 1. 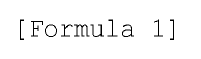 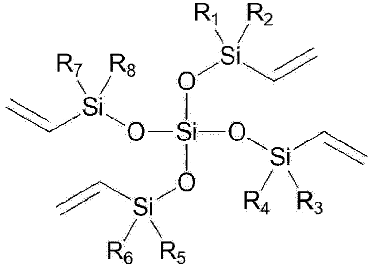
   In Formula 1,
   R₁ to R₈ are each independently an alkyl group of 1 to 10 carbon atoms.
(2) The present invention provides the composition for an encapsulant film according to (1), wherein, in Formula 1, R₁ to R₈ are each independently an alkyl group of 1 to 6 carbon atoms.
(3) The present invention provides the composition for an encapsulant film according to (1) or (2), wherein the crosslinking auxiliary agent is one or more selected from the group consisting of tetrakis(vinyldimethylsiloxy)silane, tetrakis(vinyldiethylsiloxy)silane and tetrakis(vinyldipropylsiloxy)silane.
(4) The present invention provides the composition for an encapsulant film according to any one among (1) to (3), wherein the crosslinking auxiliary agent is 0.01 parts by weight to 1 part by weight based on 100 parts by weight of the composition for an encapsulant film.
(5) The present invention provides the composition for an encapsulant film according to any one among (1) to (4), further comprising an allyl group-containing compound as the crosslinking auxiliary agent, wherein the allyl group-containing compound comprises one or more selected from the group consisting of triallyl isocyanurate, triallyl cyanurate, diallyl phthalate, diallyl fumarate and diallyl maleate.
(6) The present invention provides the composition for an encapsulant film according to (5), wherein a mole ratio of the compound represented by Formula 1 and the allyl group-containing compound is 1: 0.1 to 1: 10.
(7) The present invention provides the composition for an encapsulant film according to any one among (1) to (6), wherein the alpha-olefin comprises one or more selected from the group consisting of propylene, 1-butene, 1-pentene, 4-methyl-1-pentene, 1-hexene, 1-heptene, 1-octene, 1-decene, 1-undecene, 1-dodecene, 1-tetradecene, 1-hexadecene and 1-eicosene.
(8) The present invention provides the composition for an encapsulant film according to any one among (1) to (7), wherein the alpha-olefin is comprised in greater than 0 to 99 mol% based on the ethylene/alpha olefin copolymer.
(9) The present invention provides the composition for an encapsulant film according to any one among (1) to (8), further comprising one or more selected from the group consisting of an unsaturated silane compound, an amino silane compound, a light stabilizer, a UV absorbent and a thermal stabilizer.
(10) The present invention provides an encapsulant film comprising the composition for an encapsulant film according to any one among (1) to (9).
(11) The present invention provides a solar cell module comprising the encapsulant film of (10).

### ADVANTAGEOUS EFFECTS

In case of manufacturing an encapsulant film using the composition for an encapsulant film according to the present invention, the immersion time of an ethylene/alpha-olefin copolymer may be reduced to improve the economic feasibility of the production process of an encapsulant film. In addition, the composition for an encapsulant film prepared using the present invention shows excellent degree of crosslinking.

### BEST MODE FOR CARRYING OUT THE INVENTION

Hereinafter, the present invention will be described in more detail to assist the understanding of the present invention.

It will be understood that words or terms used in the present disclosure and claims shall not be interpreted as the meaning defined in commonly used dictionaries. It will be further understood that the words or terms should be interpreted as having a meaning that is consistent with their meaning in the context of the relevant art and the technical idea of the invention, based on the principle that an inventor may properly define the meaning of the words or terms to best explain the invention.

### <Composition for encapsulant film>

The composition for an encapsulant film of the present invention is characterized in including (a) an ethylene/alpha-olefin copolymer, (b) a crosslinking agent, (c) a crosslinking auxiliary agent, and (d) a silane coupling agent, and the crosslinking auxiliary agent includes a compound represented by Formula 1.

Hereinafter, each component will be explained in detail.

### (a) Ethylene/alpha-olefin copolymer

The composition for an encapsulant film of the present invention includes an ethylene/alpha-olefin copolymer. The ethylene/alpha-olefin copolymer is prepared by copolymerizing ethylene and an alpha-olefin-based monomer, and in this case, an alpha-olefin which means a moiety derived from an alpha-olefin-based monomer in the copolymer may be an alpha-olefin of 4 to 20 carbon atoms, particularly, propylene, 1-butene, 1-pentene, 4-methyl-1-pentene, 1-hexene, 1-heptene, 1-octene, 1-decene, 1-undecene, 1-dodecene, 1-tetradecene, 1-hexadecene, 1-eicosene, etc., and any one among them or mixtures of two or more thereof may be used.

Among them, the alpha-olefin may be 1-butene, 1-hexene or 1-octene, preferably, 1-butene, 1-hexene, or the combinations thereof.

In addition, in the ethylene/alpha-olefin copolymer, the alpha-olefin content may be suitably selected in the range satisfying the physical conditions, particularly, greater than 0 to 99 mol%, or 10 to 50 mol%, without limitation.

In the present invention, a preparation method or an obtaining route of the ethylene/alpha-olefin copolymer is not limited, and suitable ones may be selected and used considering the physical properties and purpose of the composition for an encapsulant film by a person skilled in the art.

### (b) Crosslinking agent

The composition for an encapsulant film of the present invention includes a crosslinking agent. The crosslinking agent is a radical initiator in the preparation step of the silane modified resin composition, and may play the role of initiating graft reaction of an unsaturated silane composition onto a resin composition. In addition, by forming a crosslinking bond in the silane modified resin composition, or between the silane modified resin composition and an unmodified resin composition during a lamination step for manufacturing an optoelectronic device, the heat resistant durability of a final product, for example, an encapsulant sheet may be improved.

The crosslinking agent may use various crosslinking agents well-known in this technical field only if it is a crosslinking compound capable of initiating the radical polymerization of a vinyl group or forming a crosslinking bond, for example, one or two or more selected from the group consisting of organic peroxides, hydroxyl peroxides and azo compounds.

For example, an encapsulant for a solar cell may include an organic peroxide as a crosslinking agent, and the organic peroxide plays the role of improving the climate resistance of the encapsulant for a solar cell.

Particularly, one or more selected from the group consisting of dialkyl peroxides such as t-butylcumylperoxide, di-t-butyl peroxide, di-cumyl peroxide, 2,5-dimethyl-2,5-di(t-butylperoxy)hexane, and 2,5-dimethyl-2,5-di(t-butylperoxy)-3-hexyne; hydroperoxides such as cumene hydroperoxide, diisopropyl benzene hydroperoxide, 2,5-dimethyl-2,5-di(hydroperoxy)hexane, and t-butyl hydroperoxide; diacyl peroxides such as bis-3,5,5-trimethylhexanoyl peroxide, octanoyl peroxide, benzoyl peroxide, o-methylbenzoyl peroxide, and 2,4-dichlorobenzoyl peroxide; peroxy esters such as t-butylperoxy isobutyrate, t-butylperoxy acetate, t-butylperoxy-2-ethylhexylcarbonate (TBEC), t-butylperoxy-2-ethylhexanoate, t-butylperoxy pyvalate, t-butylperoxy octoate, t-butylperoxyisopropyl carbonate, t-butylperoxybenzoate, di-t-butylperoxyphthalate, 2,5-dimethyl-2,5-di(benzoylperoxy)hexane, and 2,5-dimethyl-2,5-di(benzoylperoxy)-3-hexyne; ketone peroxides such as methyl ethyl ketone peroxide and cyclohexanone peroxide, lauryl peroxide, and azo compounds such as azobisisobutyronitrile and azobis(2,4-dimethylvaleronitrile), may be used, without limitation.

The organic peroxide may be an organic peroxide having a one-hour half-life temperature of 120 to 135°C, for example, 120 to 130°C, 120 to 125°C, preferably, 121°C. The "one-hour half-life temperature" means a temperature at which the half-life of the crosslinking agent becomes one hour. According to the one-hour half-life temperature, the temperature at which radical initiation reaction is efficiently performed may become different. Therefore, in case of using the organic peroxide having the one-hour half-life temperature in the above-described range, radical initiation reaction, that is, crosslinking reaction in a lamination process temperature for manufacturing an optoelectronic device may be effectively performed.

The crosslinking agent may be included in 0.01 parts by weight to 2 parts by weight, for example, 0.05 parts by weight to 1.5 parts by weight, 0.1 to 1.5 parts by weight or 0.5 to 1.5 parts by weight based on 100 parts by weight of the ethylene alpha-olefin copolymer. If the crosslinking agent is included in the above-described range, the improving effects of heat resistant properties may be sufficient, the moldability of the encapsulant film may be excellent, and the problems of generating process limitation or deteriorating the physical properties of the encapsulant may not arise.

### (c) Crosslinking auxiliary agent

The composition for an encapsulant film of the present invention includes a crosslinking auxiliary agent, and the crosslinking auxiliary agent includes a compound represented by Formula 1.

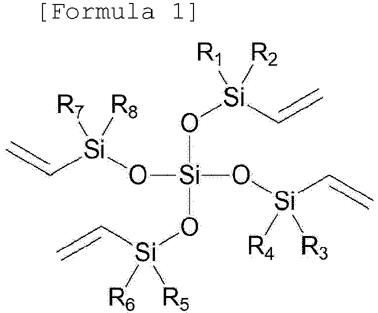

In Formula 1,
R₁ to R₈ are each independently an alkyl group of 1 to 10 carbon atoms.

In Formula 1, R₁ to R₈ may be each independently an alkyl group of 1 to 6 carbon atoms, or an alkyl group of 1 to 3 carbon atoms, for example, a methyl group, an ethyl group or a propyl group.

More particularly, the crosslinking auxiliary agent may be one or more selected from the group consisting of tetrakis(vinyldimethylsiloxy)silane, tetrakis(vinyldiethylsiloxy)silane and tetrakis(vinyldipropylsiloxy)silane.

The crosslinking auxiliary agent used in the present invention has high hydrophobicity and low viscosity of a liquid phase when compared to triallyl isocyanurate (TAIC), or the like, commonly used, and has excellent compatibility with an ethylene/alpha-olefin copolymer to improve the immersion rate of the ethylene/alpha-olefin copolymer in the composition for an encapsulant film.

In addition, in case of using a crosslinking auxiliary agent having low viscosity and two double bonds, like 1,4-cyclohexanedimethanol divinyl ether, the immersion rate may be fast, but double bonds for performing crosslinking reaction are insufficient, and there are problems of reducing the degree of crosslinking.

By including the crosslinking auxiliary agent in the composition for an encapsulant film, the degree of crosslinking of the composition for an encapsulant film may be increased by the aforementioned crosslinking agent, and accordingly, the heat resistance and durability of a final product, for example, an encapsulant film may be improved even further.

The crosslinking auxiliary agent may be 0.01 parts by weight to 1 part by weight, particularly, 0.05 parts by weight or more, 0.1 parts by weight or more, 0.2 parts by weight or more, or 0.3 parts by weight or more, and 1.0 part by weight or less, or 0.8 parts by weight or less based on 100 parts by weight of the ethylene/alpha-olefin copolymer.

Within the above-described range, effects of improving heat resistant properties and increasing the immersion rate of the ethylene/alpha-olefin copolymer through the crosslinking auxiliary agent may be sufficiently achieved, and the deterioration of the physical properties of the encapsulant film may be suppressed.

In the present invention, the composition for an encapsulant film may additionally include an allyl group-containing compound as the crosslinking auxiliary agent, and in this case, the allyl group-containing compound includes one or more selected from the group consisting of triallyl isocyanurate, triallyl cyanurate, diallyl phthalate, diallyl fumarate and diallyl maleate.

Here, the mole ratio of the compound represented by Formula 1 and the allyl group-containing compound may be 1: 0.1 to 1: 10, particularly, 1: 0.15 to 1: 5, more particularly, 1: 0.2 to 1: 2.

Within the above-described range, the immersion time of the ethylene/alpha-olefin copolymer may be reduced, and the degree of crosslinking of the composition for an encapsulant film may be increased.

### (d) Silane coupling agent

The composition for an encapsulant film of the present invention may include a silane coupling agent, and the silane coupling agent may play the role of improving the adhesiveness of an encapsulant film and a solar cell.

The silane coupling agent may use, for example, one or more selected from the group consisting of N-(β-aminoethyl)-γ-aminopropyltrimethoxysilane, N-(β-aminoethyl)-γ-aminopropylmethyldimethoxysilane, γ-aminopropyltriethoxysilane, γ-glycidoxypropyltrimethoxysilane, and γ-methacryloxypropyltrimethoxysilane (MEMO), without limitation.

The silane coupling agent may be included in 0.1 to 0.4 parts by weight based on 100 parts by weight of the composition for an encapsulant film. If the amount used of the silane coupling agent is in the above-described range, adhesiveness with glass during manufacturing a solar cell module may be excellent, and the deterioration of long-term performance of the module due to water penetration may be prevented.

In addition, the composition for an encapsulant film of the present invention may additionally include one or more selected from the group consisting of an unsaturated silane compound, an amino silane compound, a light stabilizer, a UV absorbent and a thermal stabilizer.

The unsaturated silane compound may be grafted into a main chain including the polymerization unit of the monomer of the copolymer of the present invention in the presence of a radical initiator, etc., and included in a polymerized type in a silane modified resin composition or an amino silane modified resin composition.

The unsaturated silane compound may be vinyltrimethoxy silane, vinyltriethoxy silane, vinyltripropoxy silane, vinyltriisopropoxy silane, vinyltributoxy silane, vinyltripentoxy silane, vinyltriphenoxy silane, or vinyltriacetoxy silane, and in an embodiment, vinyltrimethoxy silane or vinyltriethoxy silane may be used among them, without limitation.

In addition, the amino silane compound may act as a catalyst for promoting hydrolysis reaction for converting an unsaturated silane compound grafted in the main chain of the copolymer, for example, a reactive functional group such as the alkoxy group of vinyltriethoxy silane into a hydroxyl group in the grafting modification step of the ethylene/alpha-olefin copolymer, to improve the adhesive strength of upper and lower glass substrates or with a back sheet composed of a fluorine resin, etc. At the same time, the amino silane compound may be directly involved as a reactant in copolymerization reaction and may provide an amino modified resin composition with a moiety having an amine functional group.

The amino silane compound is a silane compound including an amine group and is not specifically limited as long as it is a primary amine or a secondary amine. For example, the amino silane compound may use aminotrialkoxysilane, aminodialkoxysilane, etc., and examples may include one or more selected from the group consisting of 3-aminopropyltrimethoxysilane (APTMS), 3-aminopropyltriethoxysilane (APTES), bis[(3-triethoxysilyl)propyl]amine, bis[(3-trimethoxysilyl)propyl]amine, 3-aminopropylmethyldiethoxysilane, 3-aminopropylmethyldimethoxysilane, N-[3-(trimethoxysilyl)propyl]ethylenediamine (DAS), aminoethylaminopropyltriethoxysilane, aminoethylaminopropylmethyldimethoxysilane, aminoethylaminopropylmethyldiethoxysilane, aminoethylaminomethyltriethoxysilane, aminoethylaminomethylmethyldiethoxysilane, diethylenetriaminopropyltrimethoxysilane, diethylenetriaminopropyltriethoxysilane, diethylenetriaminopropylmethyldimethoxysilane, diethyleneaminomethylmethyldiethoxysilane, (N-phenylamino)methyltrimethoxysilane, (N-phenylamino)methyltriethoxysilane, (N-phenylamino)methylmethyldimethoxysilane, (N-phenylamino)methylmethyldiethoxysilane, 3-(N-phenylamino)propyltrimethoxysilane, 3-(N-phenylamino)propyltriethoxysilane, 3-(N-phenylamino)propylmethyldimethoxysilane, 3-(N-phenylamino)propylmethyldiethoxysilane, and N-(N-butyl)-3-aminopropyltrimethoxysilane. The amino silane compound may be used alone or as a mixture type.

The light stabilizer may capture the active species of the photothermal initiation of a resin to prevent photooxidation according to the use applied of the composition. The type of the light stabilizer used is not specifically limited, and for example, known compounds such as a hindered amine-based compound and a hindered piperidine-based compound may be used.

The UV absorbent absorbs ultraviolet rays from the sunlight, etc. and transforms into harmless thermal energy in a molecule, and may play the role of preventing the excitation of the active species of photothermal initiation in the resin composition. Particular types of the UV absorbent used are not specifically limited, and for example, one or a mixture of two or more of benzophenone-based, benzotriazole-based, acrylnitrile-based, metal complex-based, hindered amine-based, inorganic including ultrafine particulate titanium oxide and ultrafine particulate zinc oxide UV absorbents, etc. may be used.

In addition, the thermal stabilizer may include a phosphor-based thermal stabilizer such as tris(2,4-di-tert-butylphenyl)phosphite, phosphorous acid, bis[2,4-bis(1,1-dimethylethyl)-6-methylphenyl]ethylester, tetrakis(2,4-di-tert-butylphenyl)[1,1-biphenyl]-4,4'-diylbisphosphonate and bis(2,4-di-tert-butylphenyl)pentaerythritol diphosphite; and a lactone-based thermal stabilizer such as the reaction product of 8-hydroxy-5,7-di-tert-butyl-furan-2-on and o-xylene, and one or two or more of them may be used.

The amounts of the light stabilizer, UV absorbent, and thermal stabilizer are not specifically limited. That is, the amounts of the additives may be suitably selected considering the use of the resin composition, the shape or density of the additives, etc. Generally, the amounts may be suitably controlled in a range of 0.01 to 5 parts by weight based on 100 parts by weight of the total solid content of the composition for an encapsulant film.

### <Encapsulant film and solar cell module>

In addition, the present invention provides an encapsulant film including the composition for an encapsulant film.

The encapsulant film of the present invention may be manufactured by molding the composition for an encapsulant film into a film or sheet shape. The molding method is not specifically limited, for example, a sheet or a film may be formed by a common process such as a T die process and extrusion. For example, the manufacture of the encapsulant film may be performed by an in situ process using an apparatus in which the preparation of a modified resin composition using the composition for an encapsulant film and a process for forming a film or a sheet are connected.

The thickness of the encapsulant film may be controlled to about 10 to 2,000 µm, or about 100 to 1,250 um considering the supporting efficiency and breaking possibility of a device in an optoelectronic device, the reduction of the weight or workability of the device, and may be changed according to the particular use thereof.

In addition, the present invention provides a solar cell module including the encapsulant film. In the present invention, the solar cell module may have a configuration in which the gaps between the solar cells disposed in series or in parallel are filled with the encapsulant film of the present invention, a glass surface is disposed on a side where the sunlight strikes, and a backside is protected by a back sheet, but is not limited thereto. Various types and shapes of the solar cell modules manufactured by including the encapsulant film in this technical field may be applied in the present invention.

The glass surface may use tempered glass for protecting the solar cells from external impact and preventing breaking, and may use low iron tempered glass having the low iron content to prevent the reflection of the sunlight and to increase the transmittance of the sunlight, without limitation.

The back sheet is a climate-resistant film protecting the backside of the solar cell module from exterior, for example, a fluorine-based resin sheet, a metal plate or metal film such as aluminum, a cyclic olefin-based resin sheet, a polycarbonate-based resin sheet, a poly(meth)acryl-based resin sheet, a polyamide-based resin sheet, a polyester-based resin sheet, a laminated composite sheet of a climate-resistant film and a barrier film, etc., without limitation.

Besides, the solar cell module of the present invention may be manufactured by any methods well-known in this technical field only if including the encapsulant film, without limitation.

The solar cell module of the present invention is manufactured using an encapsulant film having excellent volume resistance, and the leakage of current outside through the movement of electrons in the solar cell module through the encapsulant film may be prevented. Accordingly, potential induced degradation phenomenon (PID) by which insulation is degraded, leakage current is generated, and the output of the module is rapidly degraded, may be largely restrained.

### Examples

Hereinafter, the present invention will be explained in more detail referring to embodiments. However, the embodiments are provided only for illustration, and the scope of the present invention is not limited thereto.

### Example 1

As an ethylene/alpha-olefin copolymer, LF675 of LG Chem, (ethylene/1-butene copolymer, density 0.877 g/cc, MI 14.0) was used.

For the immersion of a crosslinking agent, a planetary mixer of Thermo Electron (Karlsruhe) GmbH was used. To 500 g of an ethylene/alpha-olefin copolymer, 1 part per hundred rubber (phr) of t-butyl 1-(2-ethylhexyl)monoperoxycarbonate (TBEC), 0.5 phr of tetrakis(vinyldimethylsiloxy)silane (TVSS), and 0.2 phr of methacryloxypropyltrimethoxysilane (MEMO) were injected. While stirring in 40 rpm, the change of a torque value in accordance with time was observed, and immersion was terminated when the torque value increased rapidly. Before being absorbed in the ethylene/alpha-olefin copolymer, the crosslinking agent played the role of a lubricant, and a low torque value was maintained, but when total crosslinking agent was absorbed, the torque value increased. Accordingly, a point where the torque value increased rapidly was defined as an immersion completion time.

After that, an encapsulant film having an average thickness of 550 um was formed at a low temperature (under conditions of 100°C or less of an extruder barrel temperature) at which high-temperature crosslinking was not achieved, was manufactured using a microextruder.

### Examples 2 to 8, and Comparative Examples 1 and 2

Encapsulant films were manufactured by the same method as in Example 1 except for changing as in Table 1 below.

**[Table 1]**

| | Type of crosslinking auxiliary agent | Weight ratio | Total amount of crosslinking auxiliary agent (phr) |
|---|---|---|---|
| Example 1 | TVSS | - | 0.5 |
| Example 2 | TVSS | - | 1.0 |
| Example 3 | TAIC:TVSS | 1:0.33 | 0.5 |
| Example 4 | TAIC:TVSS | 1:0.66 | 0.5 |
| Example 5 | TAIC:TVSS | 1: 1 | 0.5 |
| Example 6 | TAIC:TVSS | 1:2 | 0.5 |
| Example 7 | TAIC:TVSS | 1:3 | 0.5 |
| Example 8 | TAIC:TVSS | 1:4 | 0.5 |
| Comparative Example 1 | TAIC | - | 0.5 |
| Comparative Example 2 | 1,4-CDDE | - | 0.5 |

| | | | |
|---|---|---|---|
| * TVSS: tetrakis(vinyldimethylsiloxy)silane * TAIC: triallyl isocyanurate *1,4-CDDE: 1,4-cyclohexanedimethanol divinyl ether | | | |

### Experimental Example 1

With respect to the encapsulant films manufactured in the Examples and Comparative Examples, physical properties were measured according to the methods below.

### (1) Immersion rate (immersion completion time)

As described above, a point where a torque value increased rapidly was considered as an immersion completion time, and the time from the initiation point of stirring to a point where immersion was completed was measured and recorded in Table 2 below.

### (2) Degree of crosslinking

The evaluation of the degree of crosslinking was performed based on China Photovoltaic Industry Association (CPIA) standard and ASTM D2765. The encapsulant film thus formed was cut into a size of 10 cm x 10 cm, and vacuum laminated at 150°C for 20 minutes (maintain vacuum for 5 minutes/pressurization for 1 minute/depressurization for 14 minutes) to obtain a crosslinked specimen.

The crosslinked specimen was cut into a suitable size, weighed by 0.5 g on a 200 mesh wire cage, and dissolved for 5 hours under xylene refluxing. After that, the specimen was dried in a vacuum oven, and the weights before and after the refluxing were compared to measure the degree of crosslinking of each specimen.

### (3) MDR torque (M_{H}-M_{L}, Nm)

For the evaluation of the degree of crosslinking, the MDR torque value of each specimen was measured using an Alpha Technologies Production moving die rheometer (MDR).

Particularly, each of the encapsulant films with 500 µm manufactured in the Examples and Comparative Examples was cut by 1 g, and four pieces were overlapped to prepare a sample of total 4 g and processed at 150°C for 20 minutes for the measurement. Under corresponding conditions, MDR torque (M_{H}-M_{L}) was calculated by contracting the M_{L} value from the M_{H} value measured. Here, M_{H} is the maximum vulcanizing torque, and M_{L} is the minimum vulcanizing torque.

**[Table 2]**

| | Immersion completion time (min) | Degree of crosslinking | M_{H}-M_{L} |
|---|---|---|---|
| Example 1 | 17 | 72.0 | 2.52 |
| Example 2 | 41 | 76.2 | 2.91 |
| Example 3 | 36 | 78.1 | 3.13 |
| Example 4 | 29 | 77.2 | 3.04 |
| Example 5 | 22 | 76.5 | 2.89 |
| Example 6 | 20 | 75.6 | 2.72 |
| Example 7 | 18 | 74.5 | 2.59 |
| Example 8 | 17 | 73.1 | 2.47 |
| Comparative Example 1 | 59 | 78.8 | 2.91 |
| Comparative Example 2 | 7 | 50.1 | 1.51 |

As in Table 2, in cases of Examples 1 to 8 using the composition for an encapsulant film of the present invention, the immersion rate was fast, the immersion completion time was reduced, and at the same time, the degree of crosslinking was also excellent degree. On the contrary, it was confirmed that in case of Comparative Example 1 using TAIC as the crosslinking auxiliary agent, the immersion rate was slow, and the immersion completion time was increased greatly when compared to the Examples, and in case of Comparative Example 2 using 1,4-CDDE as the crosslinking auxiliary agent, the degree of crosslinking was degraded. In addition, in cases of Examples 3 to 8, using the mixtures of TVSS and TAIC as the crosslinking auxiliary agent, the physical properties of the immersion rate or the degree of crosslinking were improved when compared to Examples 1 and 2, using TVSS solely. Particularly, it could be found that both the immersion rate and the degree of crosslinking were excellent in Examples 3 to 6.

As described above, in case of using the composition for an encapsulant film according to the present invention, effects of reducing the immersion time could be achieved, while showing the suitable level of the degree of crosslinking.

## Claims

1. A composition for an encapsulant film, comprising an ethylene/alpha-olefin copolymer, a crosslinking agent, a crosslinking auxiliary agent and a silane coupling agent, wherein
the crosslinking auxiliary agent comprises a compound represented by the following Formula 1: 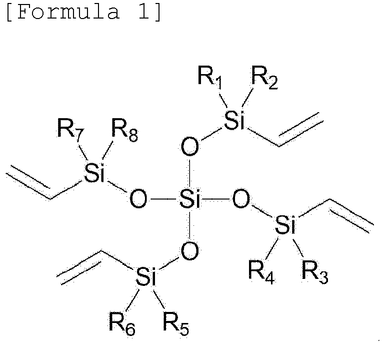
in Formula 1,
R₁ to R₈ are each independently an alkyl group of 1 to 10 carbon atoms.

2. The composition for an encapsulant film according to claim 1, wherein, in Formula 1, R₁ to R₈ are each independently an alkyl group of 1 to 6 carbon atoms.

3. The composition for an encapsulant film according to claim 1, wherein the crosslinking auxiliary agent is one or more selected from the group consisting of tetrakis(vinyldimethylsiloxy)silane, tetrakis(vinyldiethylsiloxy)silane and tetrakis(vinyldipropylsiloxy)silane.

4. The composition for an encapsulant film according to claim 1, wherein the crosslinking auxiliary agent is 0.01 parts by weight to 1 part by weight based on 100 parts by weight of the composition for an encapsulant film.

5. The composition for an encapsulant film according to claim 1, further comprising an allyl group-containing compound as the crosslinking auxiliary agent, wherein
the allyl group-containing compound comprises one or more selected from the group consisting of triallyl isocyanurate, triallyl cyanurate, diallyl phthalate, diallyl fumarate and diallyl maleate.

6. The composition for an encapsulant film according to claim 5, wherein a mole ratio of the compound represented by Formula 1 and the allyl group-containing compound is 1: 0.1 to 1: 10.

7. The composition for an encapsulant film according to claim 1, wherein the alpha-olefin comprises one or more selected from the group consisting of propylene, 1-butene, 1-pentene, 4-methyl-1-pentene, 1-hexene, 1-heptene, 1-octene, 1-decene, 1-undecene, 1-dodecene, 1-tetradecene, 1-hexadecene and 1-eicosene.

8. The composition for an encapsulant film according to claim 1, wherein the alpha-olefin is comprised in greater than 0 to 99 mol% based on the ethylene/alpha olefin copolymer.

9. The composition for an encapsulant film according to claim 1, further comprising one or more selected from the group consisting of an unsaturated silane compound, an amino silane compound, a light stabilizer, a UV absorbent and a thermal stabilizer.

10. An encapsulant film comprising the composition for an encapsulant film according to any one of claims 1 to 9.

11. A solar cell module comprising the encapsulant film of claim 10.
